# EUROPEAN PATENT APPLICATION

(11) **EP 4 625 482 A2**
(43) Date of publication of application: **01.10.2025**
(21) Application number: 25166060.1
(22) Date of filing: 25.03.2025
(51) Int. Cl.: H01L 21/67

(54) **SUBSTRATE PROCESSING APPARATUS AND SUBSTRATE PROSESSING METHOD**

(30) Priority: 28.03.2024 JP 2024053064
(71) Applicant: Shibaura Mechatronics Corporation, Yokohama-shi, Kanagawa 247-8610 (JP)
(72) Inventor: KANAI, Takahiro, Yokohama-shi (JP)
(74) Representative: Kramer Barske Schmidtchen Patentanwälte PartG mbB

(57) **Abstract**

A substrate processing apparatus and a substrate processing method that can improve the cleanliness of the substrate are provided. The substrate processing apparatus 1 of the present embodiment includes the rotation body 10 including the placement portion 13 to place the substrate W with the processed surface so that the space is maintained between the surface of the rotation body 10 facing the substrate W and the surface of the substrate W opposite the processed surface; the rotation driver 16 that rotates the rotation body 10, the liquid suppliers 30 and 40 that supply the processing liquid L1 and L2 on the processed surface of the substrate W, the cooler 20 that supplies the cooling gas G to the space between the substrate W and the placement portion 13, and the remover 90 that removes the droplet D on the surface of the rotation body facing the substrate W.

## Description

### CROSS-REFERENCE TO RELATED APPLICATION

This application is based upon and claims the benefit of priority from Japan Patent Application No. 2024-053064, filed on March 28, 2024, the entire contents of which are incorporated herein by reference.

### FIELD OF INVENTION

The present disclosure relates to a substrate processing apparatus and a substrate processing method.

### BACKGROUND

A freeze cleaning method is known as a method to remove and clean foreign substances such as particles attached on a processed surface of substrates such as templates for imprinting, masks for photolithography, and semiconductor wafers, etc.

In the freeze cleaning method, various liquid may be used as liquid used for cleaning. When using pure water for cleaning, firstly, pure water and cooling gas are supplied on the processed surface of the rotated substrate. Next, the supplying of pure water is stopped, and a part of the supplied pure water is drained from the substrate to form water film (liquid film) on the processed surface of the substrate. The water film is frozen by the cooling gas supplied on the substrate. When the water film is frozen and forms ice film, the foreign substance such as particles are captured by the ice film and are separated from the processed surface of the substrate. Next, pure water is supplied to melt the ice film, and the foreign substance is removed from the processed surface of the substrate together with pure water.

However, if the cooling gas is supplied from a side where the water film is formed on the substrate, the water film starts to freeze from the surface side (a side of the water film opposite the substrate side). When the water film is frozen from the surface side, it becomes difficult to separate the foreign substance attached on the processed surface of the substrate from the processed surface of the substrate. Therefore, a technology to supply the cooling gas from the surface side opposite the processed surface of the substrate (a surface of the substrate opposite the side where the water film is formed) .

### SUMMARY OF INVENTION

### PROBLEMS TO BE SOLVED BY INVENTION

However, when the cooling gas is supplied on the substrate, not only the substrate, but a rotation body including a placement portion to place the substrate is also cooled. AS the rotation body is cooled and temperature thereof is decreased, ambient atmosphere is cooled by the cooled rotation body, causing condensation on a surface of the rotation body facing the substrate. Due to condensation, droplets containing particles and others from the atmosphere remain on the surface of the rotation body facing the substrate. This remaining droplet might contaminate the substrate, especially the surface opposite the processed surface.

The embodiment of the present disclosure is proposed to address the above problems, and the objective is to provide a substrate processing apparatus and a substrate processing method that can improve the cleanliness of the substrate.

### MEANS TO SOLVE THE PROBLEM

A substrate processing apparatus according to an embodiment of the present disclosure includes: a rotation body including a placement portion to place a substrate with a processed surface so that space is maintained between a surface of the rotation body facing the substrate and a surface of the substrate opposite the processed surface; a rotation driver that rotates the rotation body; a liquid supplier that supplies liquid on the processed surface of the substrate; a cooler that supplies cooling gas to the space between the substrate and the placement portion; and a remover that removes a droplet on a surface of the rotation body facing the substrate.

A substrate processing method according to an embodiment of the present disclosure includes: placing a substrate in a placement portion; rotating a rotation body including the placement portion while the substrate is place on the placement portion; supplying liquid on a processed surface of the substrate that is a surface opposite the placement portion; supplying cooling gas in space between the substrate and the placement portion and freezing the liquid supplied on the processed surface; and removing a droplet on a surface of the rotation body facing the substrate.

### EFFECT OF INVENTION

According to the embodiment of the present disclosure, the cleanliness of the substrate can be improved.

### BRIEF DESCRIPTION OF DRAWINGS

Fig. 1 is an overall configuration diagram illustrating the configuration of the substrate processing apparatus of the first embodiment before the substrate is carried in.
Fig. 2 is an overall configuration diagram illustrating the configuration of the substrate processing apparatus of the first embodiment when the substrate is carried in.
Fig. 3 is a configuration diagram illustrating the configuration of the rotation body, the detector, and the remover of the substrate processing apparatus of the first embodiment.
Fig. 4 is a flowchart illustrating the operation of the substrate processing apparatus of the first embodiment.
Fig. 5 is a schematic diagram illustrating the configuration of the rotation body, the detector, and the remover of the first embodiment after the substrate is carried out.
Fig. 6 is a schematic diagram illustrating the position of the sensor of the detector of the first embodiment when detecting the droplet.
Fig. 7 is a schematic diagram illustrating the position of the nozzle of the remover of the first embodiment when detecting the droplet.
Fig. 8 is a schematic diagram illustrating the configuration of the remover of the modified example of the first embodiment.
Fig. 9 is a schematic diagram illustrating the configuration of the remover of the modified example of the first embodiment.
Fig. 10 is an overall configuration diagram illustrating the configuration of the substrate processing apparatus of the modified example of the first embodiment when the substrate is carried in.
Fig. 11 is a plan diagram illustrating the configuration of the distribution plate of the modified example of the first embodiment before the substrate is carried in.
Fig. 12 is an explanatory diagram illustrating the remaining position of the droplet in the modified example of the first embodiment.
Fig. 13 is a schematic diagram illustrating the position of the nozzle of the remover of the modified example of the first embodiment when removing the droplet.

### EMBODIMENTS

### [1. First Embodiment]

### [1-1. Summary of Apparatus]

Hereinafter, embodiments of the present disclosure will be described referring to the figures. Note that, in the figures, the same configuration is labeled with the same sign, and the detailed description is omitted as appropriate. For example, a substrate W that is the processing target may be semiconductor wafers, templates for imprinting, mask substrates for photolithography, and plates used in MEMS (Micro Electro Mechanical Systems), etc. However, the application of the substrate W is not limited thereto. If the substrate W is the mask for photolithography, the planar shape of the substrate W may be substantially rectangular. In the present embodiment, the planar shape of the substrate W is circular. Furthermore, a surface of the substrate W on which an unevenness is formed is called the processed surface. For example, the unevenness may be a pattern.

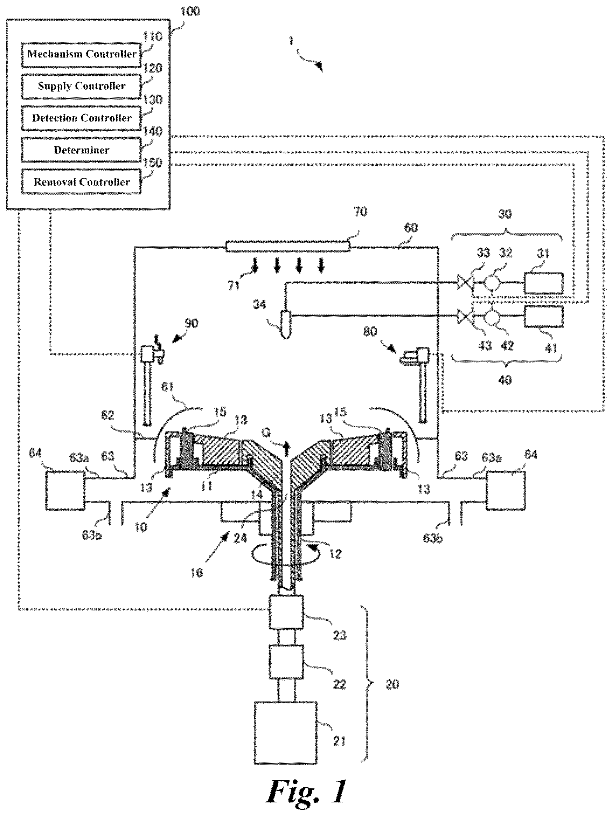

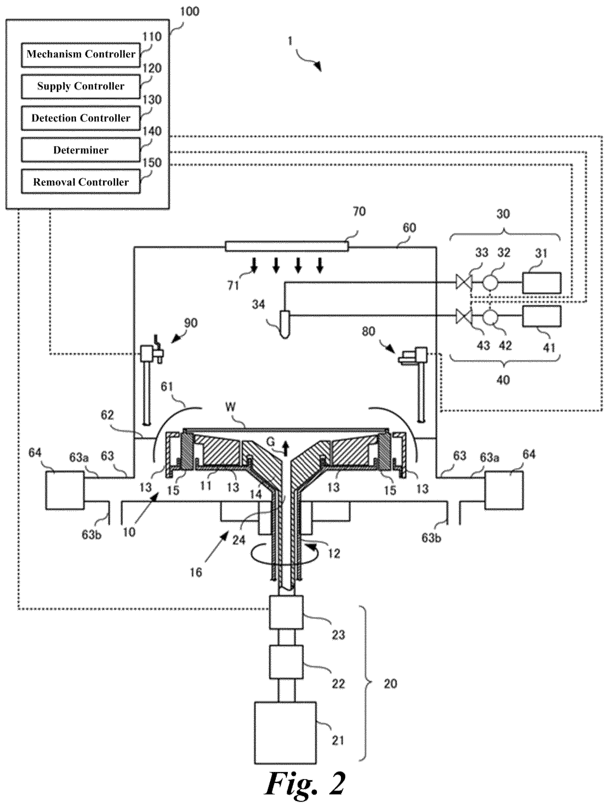

As illustrated in Figs. 1 and 2, a substrate processing apparatus 1 of the present embodiment performs cleaning on the processed surface of the substrate W by freeze cleaning method.

In the freeze cleaning method, the cooling gas is used to freeze liquid supplied on the processed surface of the substrate W. In this case, the liquid on the processed surface is cooled and frozen by supplying liquid on the processed surface of the substrate W and supplying the cooling gas from the surface side opposite the processed surface of the substrate W to cool the substrate W, while rotating the substrate W. Therefore, the substrate processing apparatus 1 includes a rotation body including a placement portion to place the substrate W so that space is maintained between a surface of the rotation body facing the substrate W and a surface of the substrate W opposite the processed surface, and the cooling gas is supplied between the placement portion and the substrate W while rotating the rotation body by a rotation driver.

By this, not only the substrate W, but the rotation body including the placement portion to place the substrate W, in particular, the surface of the rotation body facing the surface of the substrate W opposite the processed surface is cooled by the cooling gas. Therefore, for example, when carrying the substrate W which has completed the cleaning of the processed surface outside a housing, ambient air at normal temperature flows into the housing around the rotation body from outside, and the ambient air that has flown in is cooled by the rotation body. When the ambient air that has flown in is cooled by the rotation body, droplets due to condensation is produced The substrate processing apparatus 1 of the present embodiment determines whether the droplet is remaining on the surface of the rotation body facing the substrate W or not, and when it is determined that the droplet is remaining, a process to remove the droplet is performed.

### [1-2. Configuration of First Embodiment]

To perform the above processing, the substrate processing apparatus 1 of the present embodiment includes a rotation body 10 having a placement portion 13 to place the substrate W, a cooler 20 that supplies cooling gas G between the substrate W and the placement portion 13, a first liquid supplier 30 that supplies first liquid (processing liquid L1) on the processed surface, a second liquid supplier 40 that supplies second liquid (processing liquid L1) on the processed surface to remove the frozen first liquid from the processed surface, a housing 60 forming space to house the rotation body 10 and others and process the substrate W, a detector 80 that detects a droplet D on a surface of the rotation body 10 facing the substrate W, a remover 90 that removes the droplet D produced on the surface of the rotation body 10 facing the substrate W, and a controller 100 that controls each unit. In below, the configuration of each unit is described in detail.

### (Rotation Body)

The rotation body 10 includes a disk-shaped rotation body base 11 and a hollow rotation shaft 12 extending in the direction opposite the placement portion 13 to place the substrate W on a center thereof. A center of the rotation body base 11 is opened, and the disk-shaped placement portion 13 with the opened center is fit in the top of the rotation body base 11. A nozzle head 14 inserted in the hollow rotation shaft 12 is provided to the opened center of the placement portion 13. The nozzle head 14 is fixed to a unillustrated frame with certain distance from the placement portion 13 and the rotation shaft 12 and does not rotate even when the rotation body 10 rotates. A through hole is formed in the center of the nozzle head 14 as a cooling nozzle 24 of the cooler 20 described later. Here, the surface of the rotation body 10 facing the substrate W (hereinafter, referred to as the facing surface) includes a surface of the placement portion 13 facing the substrate and a surface of the nozzle head 14 facing the substrate W.

A plurality of holders 15 is provided in the outer circumference of the placement portion 13 at predetermined intervals. The substrate W is placed on this holder 15, so that the substrate W is placed on the placement portion 13 with space between the substrate W and the placement portion 13. The rotation shaft 12 provided in the rotation body base 11 is connected to a rotation driver 16 supported by an unillustrated frame, etc. The rotation body base 11, the placement portion 13, and the holder 15 rotates together by the rotation driver 16 as the rotation shaft 12 as an axis.

It is preferable that the rotation body base 11 and the placement portion 13 is formed by material that is resistant against the processing liquid L1 and L2, for example, fluorine-based resin such as PTFE (Polytetrafluoroethylene) and PCTFE (Polychlorotrifluoroethylene), etc.

The holder 15 rotates around an axis in parallel with the rotation shaft 12 of the rotation body 10 and moves between a holding position to contact the periphery of the substrate W and hold the substrate W and a release position to move away from the periphery of the substrate W and release the substrate W by an unillustrated driving mechanism built in the rotation body 10.

### (Cooler)

The cooler 20 supplies the cooling gas G to a space between the substrate W and the placement portion 13. The cooler 20 includes a cooling gas generator 21 provided outside the housing 60, a filter 22, a flow controller 23, and the cooling nozzle 24 that is the through hole formed in the nozzle head 14. The cooling gas G supplied to the space between the substrate W and the placement portion 13 is guided to the outer circumferential side of the placement portion 13 and cools the entire substrate W.

The cooling gas generator 21 stores coolant and generates the cooling gas G. The coolant is liquefied cooling gas G. The cooling gas G is not particularly limited if said gas does not easily react with the material of the substrate W and does not contain moisture, and for example, may be inert gas such as nitrogen gas, helium gas, or argon gas.

The cooling gas generator 21 has a tank that stores the coolant and a vaporization unit that vaporizes the coolant stored in the tank. The temperature of the generated cooling gas G may be any temperature if the cooling gas can cool the processing liquid L1 to the temperature lower than the freezing point of the processing liquid L1 to a supercooled state. Therefore, the temperature of the generated cooling gas G may be the temperature lower than the freezing point of the processing liquid L1 and is -170 degrees, for example.

The filter 22 is provided in a pipe connecting the cooling gas generator 21 and the cooling nozzle 24. The filter 22 removes foreign substances such as particles contained in the generated cooling gas G.

The flow controller 23 is provided in the piping connecting the cooling gas generator 21 and the cooling nozzle 24. The flow controller 23 controls a flow rate of the cooling gas G supplied to the space between the substrate W and the placement portion 13. For example, the flow controller 23 may be MFC (Mass Flow Controller), etc. Furthermore, the flow controller 23 may indirectly control the flow rate of the cooling gas G by controlling the supply pressure of the cooling gas G. In this case, for example, the flow controller 23 may be APC (Automatic Pressure Controller), etc.

### (First Liquid Supplier)

The first liquid supplier 30 supplies the processing liquid L1 on the processed surface of the substrate W. The first liquid supplier 30 has a liquid storage 31 that stores the processing liquid L1, a supplier 32 such as a pump, a flow controller 33 such as a flow controlling valve, and a liquid nozzle 34 that discharges the processing liquid L1 on the processed surface of the substrate W. The liquid storage 31 is connected to the liquid nozzle 34 via a piping. The supplier 32 and the flow controller 33 are provided in the piping connecting the liquid storage 31 and the liquid nozzle 34. The liquid storage 31,the supplier 32, and the flow controller 33 are provided outside the housing 60, and the liquid nozzle 34 is provided inside the housing 60. The processing liquid L1 is not particularly limited if the liquid does not easily react with the material of the substrate W and increases its volume when frozen. For example, the processing liquid L1 may be pure water, ultrapure water, or liquid mainly formed of water.

A tip of the liquid nozzle 34 faces almost the center of the processed surface of the substrate W held by the holder 15. The processing liquid L1 discharged from the liquid nozzle 34 to the center of the processed surface of the substrate W spreads from the center of the processed surface toward the outer circumference of the processed surface by centrifugal force produced when the substrate W rotates, and forms liquid film with certain thickness on the processed surface of the substrate W.

### (Second Liquid Supplier)

The second liquid supplier 40 supplies the processing liquid L2 on the processed surface of the substrate W to remove the frozen processing liquid L1. The second liquid supplier 40 has a liquid storage 41 that stores the processing liquid L2, a supplier 42 such as a pump, and a flow controller 43 such as a flow controlling valve. The liquid storage 41 is connected to the liquid nozzle 34 of the first liquid supplier 30 via a piping. Therefore, the liquid nozzle 34 discharges the processing liquid L2 on the processed surface of the substrate W. The supplier 42 and the flow controller 43 are provided in the piping connecting the liquid storage 41 and the liquid nozzle 34. The liquid storage 41,the supplier 42, and the flow controller 43 are provided outside the housing 60. The processing liquid L2 is not particularly limited if the liquid does not easily react with the material of the substrate W and is difficult to remain on the substrate W in a drying process describe later. For example, the processing liquid L2 may be pure water, ultrapure water, or mixture solution of water and alcohol. The processing liquid L2 may be the same as the processing liquid L1. In this case, the second liquid supplier 40 can be omitted. Furthermore, although the liquid nozzle 34 is used for the nozzle to discharge both processing liquid L1 and processing liquid L2 in the example, a liquid nozzle to discharge the processing liquid L1 and a liquid nozzle to discharge the processing liquid L2 may be provided separately.

### (Housing)

The housing 60 has a box-shape and forms space for housing therein each mechanism, such as the rotation body 10 including the placement portion 13 to place the substrate W, and for processing the substrate W. Furthermore, an unillustrated transportation port to carry in and out the substrate W is provided to the housing 60. An air blower 70 supplies air 71 from an upper portion of the housing 60 toward the substrate W. The air blower 70 is provided on a ceiling of the housing 60. Note that, the air blower 70 may be provided on a side of the housing 60 at the ceiling side. The air blower 70 may include an air blower such as a fan, and a filter. For example, the filter may be a HEPA filter (High Efficiency Particulate Air Filter). A cover 61 is provided inside the housing 60. The cover 61 receives the processing liquid L1 and the processing liquid L2 drained outside the substrate W by rotation of the substrate W. A partition plate 62 is provided inside the housing 60. The partition plate 62 is provided between the outer surface of the cover 61 and the inner surface of the housing 60. An outlet 63 is provided on a side of the housing 60 at the bottom side. The cooling gas G, the air 71, the ambient air flown into the housing 60, the processing liquid L1, and the processing liquid L2 are drained outside the housing 60 from the outlet 63.

An exhaust pipe 63a is connected to the outlet 63, and an exhaustion unit (pump) 64 to exhaust the cooling gas G, the air 71, and the ambient air flown into the housing 60 is connected to the exhaust pipe 63a. Furthermore, a drain pipe 63b to drain the processing liquid L1 and L2 is connected to the outlet 63.

### [1-3. Configuration of Detector and Remover]

The substrate processing apparatus 1 of the present embodiment with the above configuration further includes the detector 80 and the remover 90 to suppress the droplet D produced due to condensation from remaining on the surface of the rotation body 10 facing the substrate W. The detail is described below.

### (Detector)

After the substrate W is cleaned and carried out, the detector 80 detects the droplet D produced due to condensation on the facing surface. The detector 80 includes a sensor 81 and a moving mechanism 82.

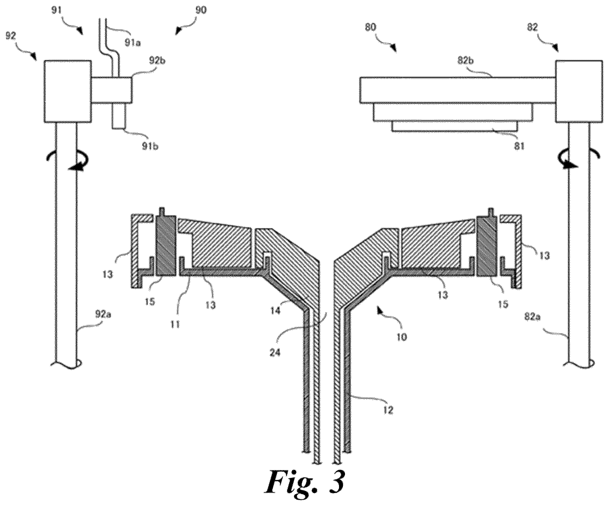

The sensor 81 can move above the facing surface of the rotation body 10 by the moving mechanism 82, and moves from the outer side of the facing surface of the rotation body 10 to the inner side of the facing surface of the rotation body 10 as indicated by an arrow in Fig. 3 and images the entire facing surface of the rotation body 10. For example, the sensor 81 may be an IR camera or a CCD camera. In the present embodiment, the sensor 81 detects the droplet D by taking a static image while the rotation of the rotation body 10 is stopped. Furthermore, the sensor 81 may be fixed above facing surface of the rotation body 10 and detects the droplet D by taking a video while the rotation body is rotating. The moving mechanism 82 moves the sensor 81 between a standby position away from above the facing surface of the rotation body 10 and an imaging position to image the facing surface of the rotation body from above. The moving mechanism 82 includes a rotation support 82a that moves the sensor 81 and an arm 82b that supports the sensor 81. The moving mechanism 82 rotates the arm 82b in the horizontal direction by the rotation support 82a and moves the sensor 81.

### (Remover)

The remover 90 removes the droplet D remaining on the facing surface of the rotation body 10 by blowing gas A. The remover 90 includes a blower 91 and a moving mechanism 92. The blower 91 has a piping 91a connected to an unillustrated gas supplier, and a tip of the piping 91a is a nozzle 91b directed to the rotation body 10. The gas A blown from the blower 91 is gas that has temperature above normal temperature and that does not contain moisture, such as N₂ gas or clean air, etc.

The moving mechanism 92 moves the nozzle 91b between a standby position away from above the facing surface of the rotation body 10 and a blowing position to blow the gas A downward from above the facing surface of the rotation body 10. Furthermore, the moving mechanism 92 swings the nozzle 91b blowing the gas A in the blowing position. The moving mechanism 92 includes a rotation support 92a that moves the nozzle 91b and an arm 92b that supports the nozzle 91b. The moving mechanism 92 rotates the arm 92b in the horizontal direction by the rotation support 92a and moves the nozzle 91b.

### (Controller)

The controller 100 controls each portion of the substrate processing apparatus 1. The controller 100 includes a processor that executes programs, a memory that stores various information such as programs and operation condition, and a driving circuit that drives each component, to realize various functions of the substrate processing apparatus 1. The controller 100 is configured of a controller that performs various controls necessary to clean the processed surface of the substrate W placed on the placement portion 13, and a controller that performs various controls necessary to remove the droplet D remaining on the facing surface of the rotation body 10.

The controller 100 includes a mechanism controller 110 that controls driving of the rotation driver 16 and the holder 15, and others, and a supply controller 120 that controls the supplying of the processing liquid L1 and the processing liquid L2, and the supplying of the cooling gas G, as controllers to clean the processed surface of the substrate W.

The controller 110 further includes a detection controller 130, a determiner 140, and a removal controller 150, as controllers to remove the droplet D remaining on the facing surface of the rotation body 10.

To detect the droplet D remaining on the facing surface of the rotation body 10, the detection controller 130 moves the sensor 81, sets the imaging condition for the sensor 81, and controls the imaging timing. When detecting the droplet D, the detection controller 130 controls the moving mechanism 82 and moves the sensor 81 from the standby position to the imaging position. After the sensor 81 reaches the imaging position, the detection controller 130 outputs an imaging command to the sensor 81 and images an image the facing surface of the rotation body 10.

The determiner 140 determines whether the droplet D is remaining on the surface of the rotation body 10 facing the substrate W or not. The determiner 140 determines whether the droplet D is remaining on the surface of the rotation body 10 facing the substrate W or not by performing image processing (for example, binarization) on the image imaged by the sensor 81 so that a region of the droplet D can be distinguished from other regions. For example, in the image imaged by the sensor 81, it is determined that the droplet D is remaining such as if a ratio of the area of the droplet D relative to the area of the facing surface of the rotation body 10 exceeds the threshold or if a ratio of the area that is not covered by the droplet D relative to the area of the facing surface of the rotation body 10 is equal to or less than the threshold.

To remove the droplet D remaining on the facing surface of the rotation body 10, the removal controller 150 moves the nozzle 91b, and controls the blowing amount of the gas A from the nozzle 91b and the blowing timing. When removing the droplet D, the removal controller 150 controls the moving mechanism 92 and moves the nozzle 91b from the standby position to the blowing position. After the nozzle 91b reaches the blowing position, the removal controller 150 controls the nozzle 91b to blow the gas A with a predetermined flow rate. The removal controller 150 of the present embodiment removes the droplet D by the remover 90 when the determiner 140 determines that the droplet D is remaining.

### [1-4. Operation of First Embodiment]

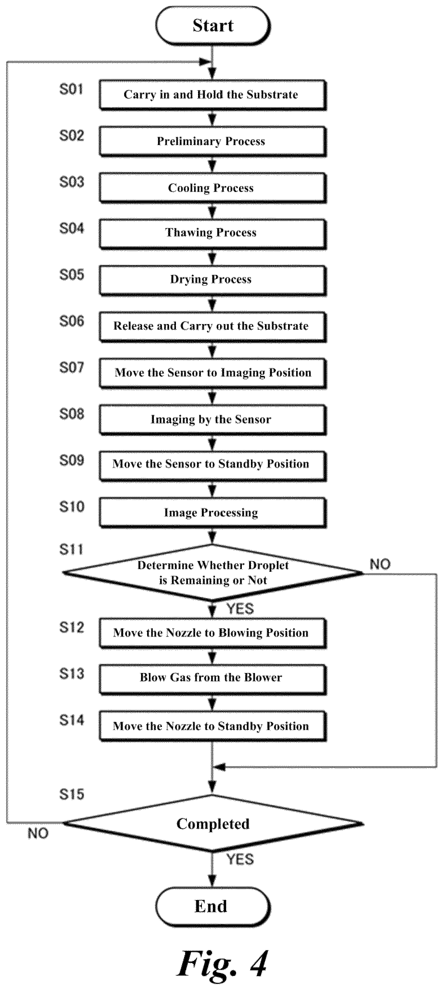

The operation of the substrate processing apparatus 1 of the present embodiment as described above is explained using the flowchart of Fig. 4, and Figs. 5 to 7, in addition to above Figs. 1 to 3. The explanation is divided into the operation to clean the processed surface of the substrate W (Steps S01 to S 06) and the operation to remove the droplet D remaining on the facing surface of the rotation body 10 (Steps S07 to S14).

### (Operation to Clean Processed Surface of Substrate W)

As illustrated in Fig. 1, before the substrate W is carried in the housing 60, the detector 80 and the remover 90 are in the standby position. In this state, the substrate W loaded on a hand of a carrying robot is carried above the rotation body 10 and is placed on the placement portion 13. As illustrated in Fig. 2, the periphery of the substrate W placed on the placement portion 13 is held by the plurality of the holders 15 (Step S01). At this time, the center of the substrate W and the axis of rotation of the rotation body 10 are positioned to match with each other.

After the substrate W is held by the holder 15, as shown in Fig. 4, the freeze cleaning process including a preliminary process, a cooling process (a supercooling process and a freezing process), a thawing process, and a drying process is performed.

In the preliminary process (Step S02), the controller 100 controls the supplier 32 and the flow controller 33 to supply the processing liquid L1 on the processed surface of the substrate W at a predetermined flow rate. The controller 100 controls the flow controller 23 to supply the cooling gas G to the space between the substrate W and the placement portion 13 from the surface side opposite the processed surface of the substrate W at a predetermined flow rate. The mechanism controller 110 controls the rotation driver 16 to rotate the substrate at predetermined rotation speed.

Here, when the substrate W is cooled by the cooling gas G supplied by the cooler 20, frost containing the foreign substance in the atmosphere in the housing 60 may attach to the substrate W, causing contamination of the substrate W. In the preliminary process, since the cooling gas G is supplied from the surface side opposite the processed surface of the substrate W and the processing liquid L1 is continually supplied on the processed surface, the attachment of the frost on the processed surface of the substrate W can be prevented while uniformly cooling the substrate W. For example, the rotation speed of the substrate W may be about 100 rpm, the flow rate of the processing liquid L1 may be about 0.3 L/min, the flow rate of the cooling gas G may be about 170 Nl/min, and the processing time in the preliminary process may be about 1800 seconds.

In the cooling process (supercooling process and freezing process) (Step S03), the supplying of the processing liquid L1 that has been supplied in the preliminary process is stopped, and the rotation speed of the substrate W is set to about 30 rpm. This rotation speed is rotation speed at a level in which the processing liquid L1 supplied to the center of the processed surface spreads to the outer circumference of the substrate W and the liquid film with uniform thickness is formed and maintained on the substrate W. That is, the controller 100 rotates the substrate W at the rotation speed slower than that of the preliminary process. Furthermore, the thickness of the liquid film of the processing liquid L1 at this time may be thickness so that convex portions of the unevenness formed on the processed surface of the substrate W can be covered. Furthermore, the flow rate of the cooling gas G is maintained at 170 NL/min. Accordingly, since the cooling gas G is continuously supplied to the space between the substrate W and the placement portion 13, the temperature of the liquid film (processing liquid L1) formed on the processed surface of the substrate W becomes lower than the temperature in the preliminary process, and the liquid film become supercooled (supercooling process). The cooler 20 continues to supply the cooling gas G to the space between the substrate W and the placement portion 13 even after the liquid film become supercooled. Since the cooling gas G is continuously supplied, the temperature of the liquid film on the processed surface of the substrate W further decreases, and at least a part of the liquid film is frozen (freezing process). By this, the foreign substance attached on the processed surface of the substrate W is separated from the processed surface by the expansion of the liquid film and is captured in the frozen liquid film.

In the thawing process (Step S04), the controller 100 controls the supplier 42 and the flow controller 43 to supply the processing liquid L2 on the processed surface of the substrate W at predetermined flow rate. Furthermore, the controller 100 controls the flow controller 23 to stop supplying the cooling gas G.

Furthermore, the controller 100 controls the rotation driver 16 to increase the rotation speed of the substrate W. If the rotation speed of the substrate W becomes faster, the processing liquid L1 and the frozen processing liquid L1 can be shaken off by centrifugal force and can be removed from the substrate W. Therefore, it becomes easy to remove the processing liquid L1 and the frozen processing liquid L1 from the substrate W. Also, at this time, the foreign substance separated from the processed surface of the substrate W is also removed together with the processing liquid L1 and the frozen processing liquid L1.

In the drying process (Step S05), the controller 100 controls the supplier 42 and the flow controller 43 to stop supplying the processing liquid L2. Furthermore, the controller 100 controls the rotation driver 16 to increase the rotation speed of the substrate W. If the rotation speed of the substrate W becomes faster, the drying of the substrate W can be performed rapidly. Note that the rotation speed of the substrate W is not particularly limited if the drying can be performed. As describe above, the substrate W can be cleaned.

In the substrate release and carrying process (Step S06), the mechanism controller 110 stops the rotation of the substrate W. Then, the hand of the carrying robot is inserted below the substrate W, the holder 15 releases the substrate W, and the hand of the carrying robot carries the substrate W out.

### (Operation to Remove Droplet Remaining on Facing Surface of Rotation Body)

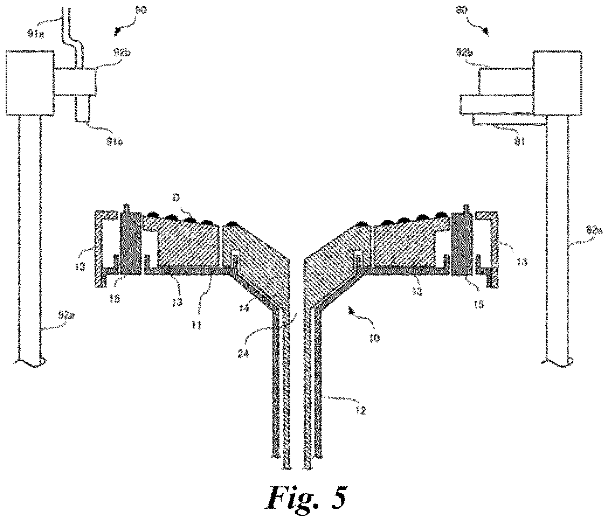

Next, the operation to remove the droplet D remaining on the facing surface of the rotation body 10 is described. As described above, the cooling gas G is supplied to the space between the substrate W and the placement portion 13 during the preliminary process and the cooling process. Then, even after the thawing process and the drying process, the temperature of the rotation body 10 including the placement portion 13 is lower than normal temperature due to the cooling gas G. For example, in this state, when the transportation port of the housing 60 is opened for carrying out the substrate W and the ambient air flows in, the ambient air at room temperature that has flown in is cooled by the cooled rotation body 10. When the ambient air at room temperature is cooled by the cooled rotation body 10, the droplet D due to condensation is produced on the facing surface of the rotation body 10 as illustrated in Fig. 5. The substrate processing apparatus 1 removes the droplet D produced on the facing surface of the rotation body 10 by the process of Step S07 onward.

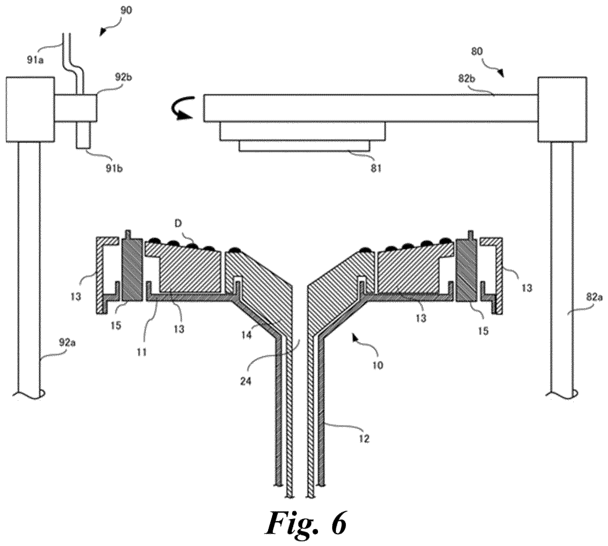

In the imaging process (Steps S07 to S09), the facing surface of the rotation body 10 is imaged. When the substrate W is carried out from the housing 60, the detection controller 130 controls the moving mechanism 82 to move the sensor 81 from the standby position to the imaging position as illustrated in Fig. 6 (Step S07). The imaging position may be one site or multiple sites above the rotation body 10. In below, the imaging position is at one site.

After the sensor 81 is moved to the imaging position, the detection controller 130 imaged the image of the facing surface of the rotation body 10 by the sensor 81 at predetermined conditions (Step S08). The result image is stored in the memory in the controller 100. After the imaging, the detection controller 130 moves the se 81 from the imaging position to the standby position (Step S09).

In the image processing process (Step S10), the determiner 140 processes the image imaged by the sensor 81. The determiner 140 processes the imaged image so that the region of the droplet D can be distinguished from other regions. The image after the image processing is stored in the memory in the controller 100.

In the determination process, the determiner 140 determines whether the droplet D is remaining on the facing surface of the rotation body 10 or not based on the processed image (Step S11). The determiner 140 determines that the droplet D is remaining when the ratio of the area of the droplet D in the image relative to the area of the facing surface of the rotation body 10 exceeds the threshold. Note that the determiner 140 may determine that the droplet D is remaining if one droplet D is present in the image.

When it is determined that the droplet D is remaining on the facing surface of the rotation body 10 (Step S11: Yes), the removing process to remove the droplet D is performed (Steps S12 to S14). The removal controller 150 controls the moving mechanism 92 and moves the nozzle 91b from the standby position to the blowing position (Step S12).

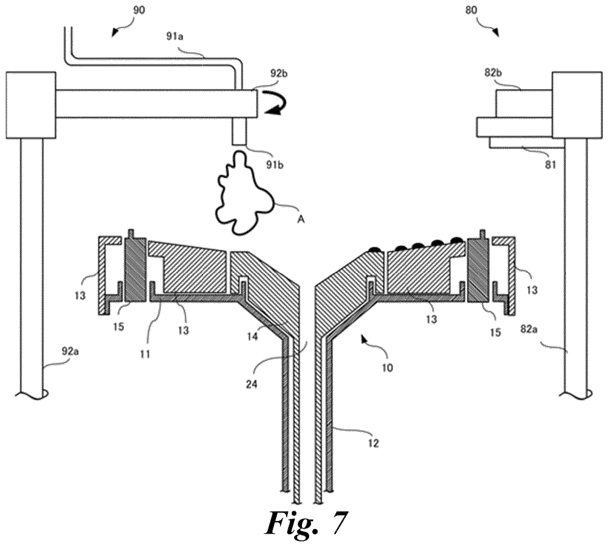

After the nozzle 91b moves to the blowing position, the removal controller 150 controls the blower 91 to blow the gas A at a predetermined flow rate as illustrated in Fig. 7 (Step S13). The gas A blown from the blower 91 blows and removes the droplet D remaining on the facing surface of the rotation body 10 outside the rotation body 10. While the blower 91 is blowing the gas A, the mechanism controller 110 controls the rotation driver 16 to rotate the rotation body 10, and the removal controller 150 controls the moving mechanism 92 to swing the nozzle 91b. By this, the droplet D remaining on the entire facing surface of the rotation body 10 is blown and removed outside the rotation body 10. Furthermore, when gas with low humidity such as dry air is used as the gas A, the droplet D can be removed not only by blowing the droplet D by blowing pressure of the gas A but also by drying.

After removing the droplet D, the mechanism controller 110 stops the rotation of the rotation body 10, and the removal controller 150 stops the blower 91 from blowing the gas A and moves the nozzle 91b from the blowing position to the standby position (Step S14). After removing the droplet D, when there is the substrate W to be processed, the process transitions to carry in the substrate W (Step S15: No). When there is no substrate W to be processed next, the processes are finished (Step S15: Yes).

When it is determined that the droplet D is not remaining in the determination process (Step S11: No), and there is the substrate W to be processed next (Step S15: No), the process transitions to carry in the substrate W (Step S01). When there is no substrate W to be processed next, the processes are finished (Step S15: Yes).

### [1-5. Effect of First Embodiment]

(1) The substrate processing apparatus 1 of the present embodiment as described above includes: the rotation body 10 including the placement portion 13 to place the substrate W with the processed surface so that the space is maintained between the surface of the rotation body 10 facing the substrate W and the surface of the substrate W opposite the processed surface; the rotation driver 16 that rotates the rotation body 10; the liquid suppliers 30 and 40 that supply the processing liquid L1 and L2 on the processed surface of the substrate W; the cooler 20 that supplies the cooling gas G to the space between the substrate W and the placement portion 13; and the remover 90 that removes the droplet D on the surface of the rotation body 10 facing the substrate W.

Therefore, the substrate processing apparatus 1 of the present embodiment can remove the droplet D on the surface of the rotation body 10 facing the substrate W by the remover 90. As a result, the droplet D is suppressed from remaining on the facing surface of the rotation body 10 and is prevented from attaching to the substrate W to be processed next, improving the cleanliness of the substrate W.

(2) In the present embodiment, the droplet D is removed when the substrate W is not placed on the placement portion 13 after the substrate W is carried out. Here, one reason the droplet D condenses on the facing surface of the rotation body 10 is because the ambient air at normal temperature that has flown inside the housing 60 is cooled by the rotation body 10 cooled by the cooling gas G when the processed surface of the substrate W was cleaned. When the substrate W is placed on the placement portion 13, since the transportation port of the housing 60 for the substrate W is closed and the inflow of the ambient air is little, the amount of the droplet D produced due to condensation of the facing surface of the rotation body 10 is small. However, when the cleaning process by the freeze cleaning method is completed and the substrate W is carried out from the housing 60, the ambient air flows into the housing 60. The ambient air that has flown in is cooled by the rotation body 10 cooled by the cooling gas G, resulting in the large amount of droplet D due to condensation remaining on the facing surface of the rotation body 10.

Therefore, in the present embodiment, the droplet D is removed by the remover 90 not when the substrate W is placed on placement portion 13, but is removed when the substrate W is not placed on the placement portion 13 on which the droplet D is easily produced. Accordingly, in the present embodiment, the situation in which the droplet D is easily produced is predicted beforehand, and the droplet D remaining on the facing surface of the rotation body 10 is removed by the remover 90, is suppressed from remaining on the facing surface of the rotation body 10, so that the attachment of the droplet D on the substrate W to be processed next can be prevented with minimum number of processes, and the cleanliness of the substrate W can be improved.

At the same time, in the present embodiment, the detector 80 detects the droplet D or the remover 90 removes the droplet D when the substrate W is not placed on the placement portion 13. By this, the detection of the droplet D by the detector 80 or the removal of the droplet D by the remover 90 will not be interfered by the substrate W, improving the detection accuracy and removal efficiency of the droplet D.

(3) The present embodiment includes the detector 80 that detects the droplet D on the facing surface of the rotation body 10, and a controller 100 that controls the remover 90 to remove the droplet D in accordance with the detection result by the detector 80. Therefore, the droplet D is removed when it is determined that the droplet D is remaining on the facing surface of the rotation body 10, improving the efficiency of the removal process of the droplet D.

(4) The remover 90 removes the droplet D on the facing surface of the rotation body 10 by blowing the gas A to the droplet D. By this, the droplet D on facing surface of the rotation body 10 can be removed in a short time. Furthermore, particles and others contained in the droplet D can be removed together with the droplet D.

The temperature of the gas A blown by the remover 90 is normal temperature or higher. By this, by blowing the gas A, the temperature of the facing surface of the rotation body 10 becomes normal temperature or higher, while the droplet D on the facing surface of the rotation body 10 is removed. Therefore, after the remover 90 removes the droplet D, the atmosphere around the rotation body 10 is cooled by the facing surface of the rotation body 10, and the droplet D is suppressed from being produced on the facing surface of the rotation body 10 again until the next substrate W is carried in.

### [2. Other Embodiment]

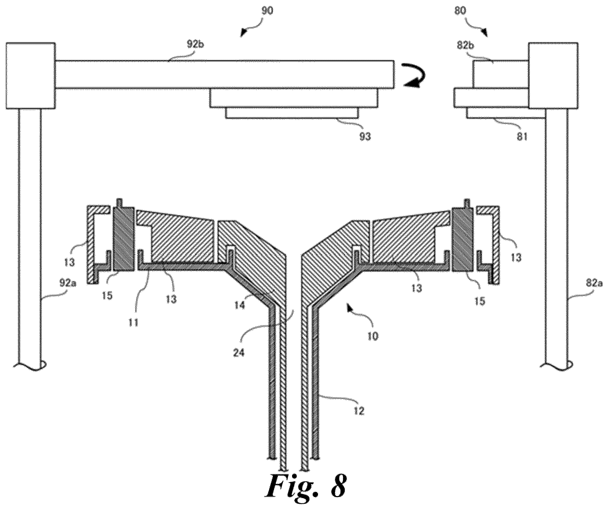

The embodiment of the present disclosure is exemplified above. However, the embodiment of the present disclosure is not limited to this description. Any modifications made by the one skilled in the art as appropriate with respect to the above embodiments are also included within the scope of the present disclosure if they include the characteristics of the present disclosure. For example, the shape, dimension, numbers, and arrangement of each component included in the substrate processing apparatus 1 are not limited to the examples and may be changed as appropriate.
(1) In the first embodiment, the remover 90 removed the droplet D by blowing the gas A to the droplet D, however, the remover 90 may be any mechanism if the droplet D can be removed, and for example, the droplet D may be removed by heating the droplet D. Fig. 8 is a diagram illustrating the configuration of the remover 90 of the modified example of the first embodiment. As illustrated in Fig. 8, the remover 90 includes a heater 93 instead of the blower 91 that blows the gas A. Furthermore, the remover 90 includes the moving mechanism 92 that can move the heater 93 between the standby position away from above the rotation body 10 and the heating position facing the rotation body 10. Furthermore, the moving mechanism 92 may be provided to raise and lower the heater 93 along the direction the rotation shaft 12 of the rotation body 10 is extending. The heater 93 generates heat when conducted with electricity. For example, the heater 93 may be an LED, a halogen lamp, or a quartz heater, etc.

The remover 90 removes the droplet D by heating and evaporating the droplet D by heat from the heater 93. While the heater 93 generating heat, the mechanism controller 110 controls the rotation driver 16 to rotate the rotation body 10, and the removal controller 150 controls the moving mechanism 92 to swing the heater 93. By this, the entire facing surface of the rotation body 10 can be heated, and the droplet D remaining on facing surface can be removed. Furthermore, since the droplet D in a wide area rather than a small area can be removed by heating the droplet D using the heater 93, the droplet D can be removed with little residue. Furthermore, by setting the temperature of the heater 93 to be the minimum temperature at which the droplet D can remove, it also becomes possible to heat the facing surface of the rotation body 10 no more than necessary. By this, the time required to lower the temperature of the facing surface of the rotation body 10 before the next substrate W is carried in can be made minimum. Furthermore, the diameter of the heater 93 may be larger than the outer diameter of the placement portion 13. In this case, the rotation of rotation body 10 and the swinging of the heater 93 while the heater is heating the droplet D can be omitted. By this, the entire facing surface of the rotation body 10 can be heated by a simple process, and the droplet D remaining on facing surface can be surely removed.

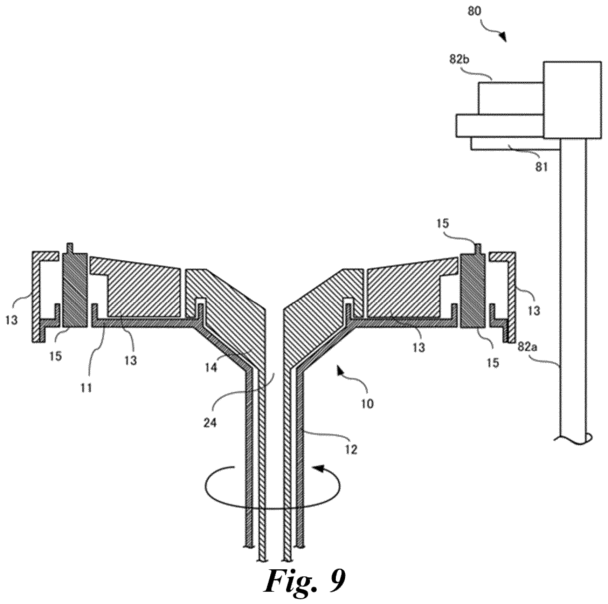

(2) Furthermore, as illustrated in Fig. 9, the remover 90 may remove the droplet D by centrifugal force produced by rotating the rotation body 10, instead of the blower 91 that blows the gas A. In this case, the nozzle head 14 is provided to be rotatable. By rotating the nozzle head 14 in addition to the rotation body base 11, the placement portion 13, and the holder 15 of the rotation body, the droplet D on the facing surface of the rotation body 10 moves to the outer circumferential side and is drained from the edge of the placement portion 13 outside the rotation body 10. By such a configuration, the process can be simplified.

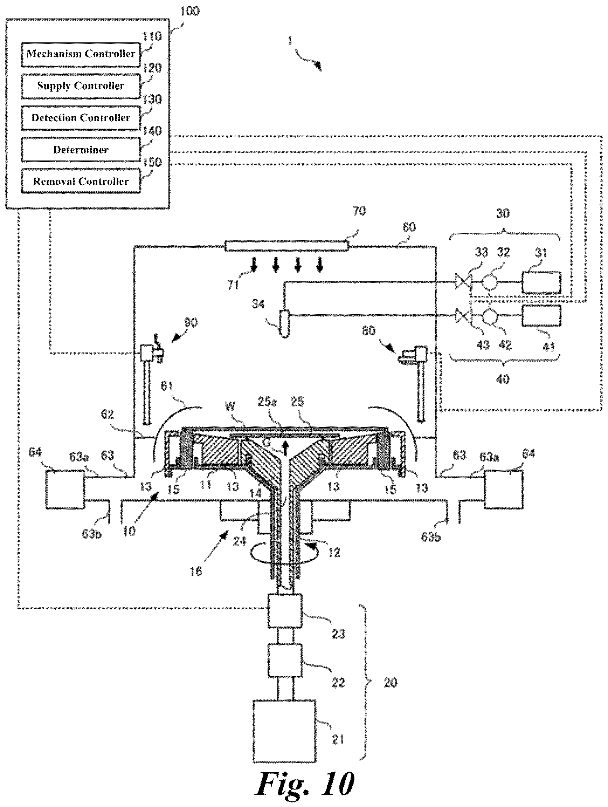

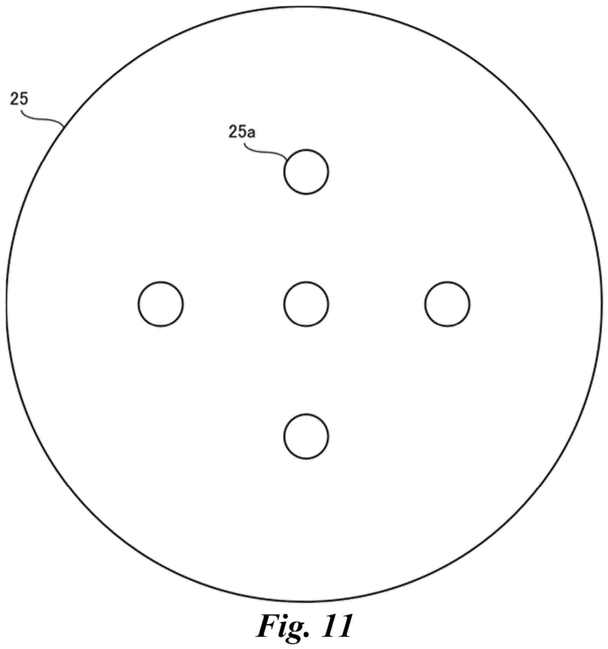

(3) As illustrated in Fig. 10, a distribution plate 25 may be provided at the discharging side of the cooling gas G of the cooling nozzle 24. This distribution plate 25 distributes the cooling gas G supplied from the cooling nozzle 24. By this, the entire substrate W can be cooled uniformly. As illustrated in Fig. 11, the distribution plate 25 is a disc-shaped member, and holes 25a are provided at multiple sites thereof. The distribution plate 25 is fixed with the nozzle head 14 via a support member 26.

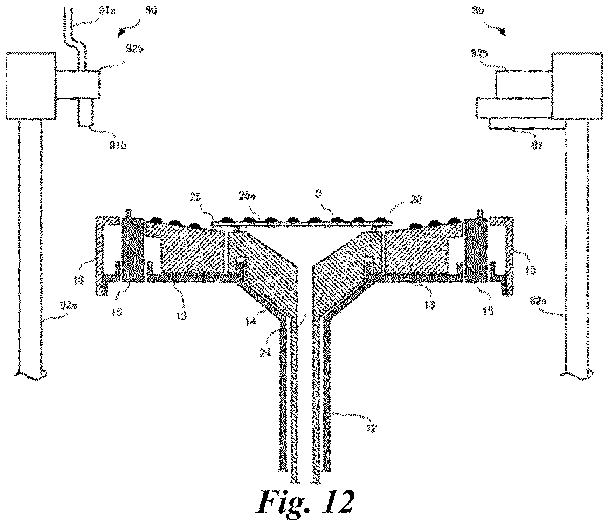

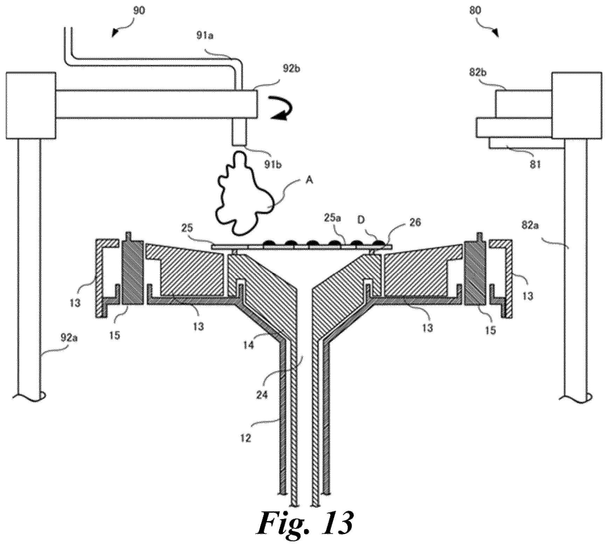

Fig. 12 is a schematic diagram illustrating the remaining droplet D in the substrate processing apparatus 1 provided with the distribution plate 25 after the substrate W has carried out. The rotation body 10 and the distribution plate 25 are cooled by the cooling gas G supplied when cleaning the substrate W. For example, in this state, when the transportation port of the housing 60 is opened for carrying out the substrate W and the ambient air flows in, the ambient air at room temperature that has flown in is cooled by the cooled rotation body 10 and distribution plate 25. Therefore, as illustrated in Fig. 12, the droplet D due to condensation is produced on the facing surface of the distribution plate 25 (a surface of the distribution plate 25 facing the substrate W) and the facing surface of the rotation body 10. Therefore, after carrying out the substrate W, when the determiner 140 determines that the droplet D is remaining on the facing surface of the rotation body 10 or the facing surface of the distribution plate 25, the blower 91 of the remover 90 blows the gas A to remove the droplet D as illustrated in Fig. 13. Furthermore, the remover 90 may remove the droplet D by centrifugal force produced by rotating the rotation body 10, instead of the blower 91 that blows the gas A. In this case, the nozzle head 14 is provided to be rotatable. By rotating the nozzle head 14, the distribution plate 25 supported by the nozzle head 14 via the support member 26 can be rotated, and the droplet D remaining on the surface of the distribution plate 25 facing the substrate W can be removed.

(4) After the remover 90 removes the droplet D, the detector 80 may detect the droplet D again. When the droplet D is detected, the remover 90 may remove the droplet D again. Furthermore, after the cleaning of the substrate W, the remover 90 may always remove the droplet D without performing the detection of the droplet D by the detector 80.

(5) When a detector such as an image sensor that detects the freezing state of the processing liquid L1 on the processed surface of the substrate W, this detector such as an image sensor may be used as the detector to detect the droplet D.

(6) The detector 80 can detect the state of the processing liquid L1 supplied on the processed surface of the substrate W, in addition to detecting the droplet D. Furthermore, the controller 100 can control the flow rate of the cooling gas G supplied by the cooler 20 in accordance with the state of the processing liquid L1 detected by the detector 80, in addition to controlling the removal of the droplet D by the remover 90. That is, by using the controller 100 for both controlling the detection and removal of the droplet D and controlling the detection of the processing liquid L1 and the flow rate of the cooling gas G as the mechanism required for the image processing and flow rate control, the configuration components of the entire substrate processing apparatus 1 can be reduced and the substrate processing apparatus 1 can be downsized.

(7) Furthermore, the substrate W with the processed surface on which the unevenness is formed is used as the processing target in the first embodiment, however, the substrate W without the unevenness may be employed. In this case, the processed surface of the substrate W is a surface that needs cleaning.

### REFERENCE SIGN

1: substrate processing apparatus
10: rotation body
11: rotation body base
12: rotation shaft
13: placement portion
14: nozzle head
15: holder
16: rotation driver
20: cooler
21: cooling gas generator
22: filter
23: flow controller
24: cooling nozzle
25: distribution plate
25a: hole
26: support member
30: first liquid supplier
31: liquid storage
32: supplier
33: flow controller
34: liquid nozzle
40: second liquid supplier
41: liquid storage
42: supplier
43: flow controller
60: housing
61: cover
62: partition plate
63: outlet
63a: exhaust pipe
63b: drain pipe
64: exhaustion unit
70: air blower
71: air
80: detector
81: sensor
82: moving mechanism
82a: rotation support
82b: arm
90: remover
91: blower
91a: piping
91b: nozzle
92: moving mechanism
92a: rotation support
92b: arm
93: heater
100: controller
110: mechanism controller
120: supply controller
130: detection controller
140: determiner
150: removal controller
A: gas
D: droplet
G: cooling gas
L1: processing liquid
L2: processing liquid
W: substrate

## Claims

1. A substrate processing apparatus (1) comprising:
a rotation body (10) including a placement portion (13) to place a substrate (W) with a processed surface so that space is maintained between a surface of the rotation body (10) facing the substrate (W) and a surface of the substrate (W) opposite the processed surface;
a rotation driver (16) that rotates the rotation body (10);
a liquid supplier (30, 40) that supplies liquid (L1, L2) on the processed surface of the substrate (W);
a cooler (20) that supplies cooling gas (G) to the space between the substrate (W) and the placement portion (13); and
a remover (90) that removes a droplet (D) on a surface of the rotation body (10) facing the substrate (W).

2. The substrate processing apparatus (1) according to claim 1, wherein the remover (90) removes the droplet (D) when the substrate (W) is not placed on the placement portion (13).

3. The substrate processing apparatus (1) according to claim 1, comprising:
a detector (80) that detects the droplet (D); and
a controller (100) that controls the remover (90) to remove the droplet (D) in accordance with a detection result by the detector (80).

4. The substrate processing apparatus (1) according to claim 3, wherein the detector (80) detects the droplet (D) when the substrate (W) is not placed on the placement portion (13).

5. The substrate processing apparatus (1) according to claim 3, wherein:
the detector (80) detects a state of the liquid (L1) supplied on the processed surface of the substrate (W), in addition to detecting the droplet (D); and
the controller (100) controls a flow rate of the cooling gas (G) supplied by the cooler (20) in accordance with the state of the liquid (L1) detected by the detector (80), in addition to controlling removal of the droplet (D) by the remover (90).

6. The substrate processing apparatus (1) according to claim 1, wherein:
the cooler (20) includes a cooling nozzle (24) that can supply the cooling gas (G), and a distribution plate (25) provided to face the substrate (W) and at a discharging side of the cooling gas (G) of the cooling nozzle (24), and
the remover (90) removes the droplet (D) on a surface of the distribution plate (25) facing the substrate (W).

7. The substrate processing apparatus (1) according to any one of claims 1 to 6, wherein the remover (90) removes the droplet (D) by blowing gas (A) to the droplet (D).

8. The substrate processing apparatus (1) according to claim 7, wherein temperature of the gas (A) blown from the remover (90) is normal temperature or higher.

9. The substrate processing apparatus (1) according to any one of claims 1 to 6, wherein the remover (90) removes the droplet (D) by heating the droplet (D).

10. The substrate processing apparatus (1) according to any one of claims 1 to 5, wherein the remover (90) removes the droplet (D) by rotating the rotation body (10).

11. The substrate processing apparatus (1) according to claim 6, wherein the remover (90) removes the droplet (D) by rotating the rotation body (10) and the distribution plate (25).

12. A substrate processing method comprising:
placing a substrate (W) in a placement portion (13);
rotating a rotation body (10) including the placement portion (13) while the substrate (W) is place on the placement portion (13);
supplying liquid (L1) on a processed surface of the substrate (W) that is a surface opposite the placement portion (13);
supplying cooling gas (G) in space between the substrate (W) and the placement portion (13), and freezing the liquid (L1) supplied on the processed surface; and
removing a droplet (D) on a surface of the rotation body (10) facing the substrate (W).
